# EUROPEAN PATENT SPECIFICATION

(11) **EP 1 798 198 B1**
(45) Date of publication and mention of the grant of the patent: **25.12.2013**
(21) Application number: 05770523.8
(22) Date of filing: 10.08.2005
(51) Int. Cl.: C01B 33/03, C01B 33/035

(54) **SILICON MANUFACTURING APPARATUS**
VORRICHTUNG ZUR HERSTELLUNG VON SILICIUM
APPAREIL DE FABRICATION DE SILICIUM

(30) Priority: 11.08.2004 JP 2004234351
(43) Date of publication of application: 20.06.2007
(73) Proprietor: Tokuyama Corporation, Shunan-shi, Yamaguchi-ken 745-8648 (JP)
(72) Inventor: NAKASHIMA, Junichirou;, shi, Yamaguchi 7458648; (JP); WAKAMATSU, Satoru;, shi, Yamaguchi 7458648; (JP); SUGIMURA, Shigeki;, shi, Yamaguchi 7458648; (JP)
(74) Representative: Hall, Matthew Benjamin
(86) International application number: PCT/JP2005/014694
(87) International publication number: WO 2006/016626

(56) References cited:
- JP-A- 2002 029 726
- JP-A- 2003 000 228
- JP-A- 2003 002 626
- JP-A- 2003 002 627
- JP-A- 2003 054 933
- JP-A- 2004 002 138

## Description

### TECHNICAL FIELD

The present invention relates to a silicon manufacturing apparatus for supplying the chlorosilanes and hydrogen to a reaction vessel from a gas supply port formed on an upper side of the reaction vessel, depositing silicon to the inside wall of the reaction vessel that has been heated, and withdrawing the deposited silicon from an opening at the bottom end portion of the reaction vessel.

### BACKGROUND ART

Conventionally, many kinds of methods of manufacturing silicon that is used as a raw material of a semiconductor and a solar battery for power generation have been known. Some of the above methods have already been implemented industrially.
For instance, one of above methods is called a siemens method. In this method, a silicon rod that has been heated up to a deposition temperature of silicon by energizing is disposed in a bell jar, and trichlorosilane (SiHCl₃) and monosilane (SiH₄) are made to come into contact with the silicon rod together with a reducing gas such as hydrogen to deposit silicon.

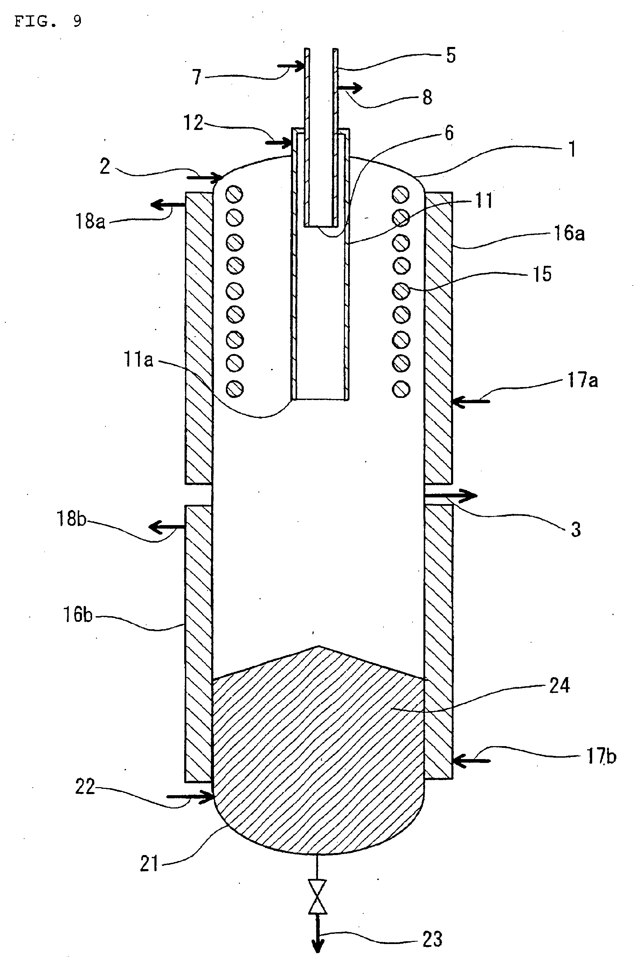

This method, by which high purity silicon can be obtained, is implemented industrially as a general method. However, since silicon is deposited in a batch system, it is necessary to repeat for each batch a series of processes such as installing of a silicon rod that is a seed, energizing, heating, depositing, cooling, and withdrawing of the silicon rod, and cleaning of the bell jar, thereby requiring complicated operations.
On the other hand, as a method capable of continuously manufacturing polycrystalline silicon, a method using an apparatus shown in Fig. 9 is proposed (see Patent documents 1 and 2). This silicon manufacturing apparatus is provided with a reaction vessel 11 made of a carbon material or the like as a base material, a raw gas supply port 6 that is disposed on an upper side of the reaction vessel 11 and that supplies the chlorosilanes, or the chlorosilanes and hydrogen into the reaction vessel 11, and a high frequency heating coil 15 disposed on the periphery of the reaction vessel 11 in a closed container 1.

The reaction vessel 11 is heated by an electromagnetic wave emitted from the high frequency heating coil 15 disposed on the periphery thereof. An inside face of the reaction vessel 11 is heated up to a temperature equivalent to or higher than a melting point of silicon or a temperature less than that at which silicon can be deposited.
The chlorosilanes supplied from the raw gas supply port 6 are made to come into contact with the heated inside face of the reaction vessel 11 to deposit silicon.

In the case in which the inside face of the reaction vessel 11 is heated up to a temperature equivalent to or higher than a melting point of silicon to deposit silicon (first method), a silicon molten solvent that has been deposited in a molten state is continuously dropped from an opening of a bottom end portion 11a of the reaction vessel 11 and is recovered in a cooling recovery chamber 21 disposed in a dropping direction.
In the case in which the inside face of the reaction vessel 11 is heated up to a temperature less than a melting point of silicon at which silicon can be deposited to deposit silicon (second method), after silicon is deposited in a solid state on the inside face of the reaction vessel 11, the inside face is heated up to a temperature equivalent to or higher than a melting point of silicon, and the part or whole of a deposited substance is molten, dropped, and recovered in a cooling recovery chamber 21 disposed in a dropping direction.

The sealing gas supply ports 12 and 2 for supplying a sealing gas such as hydrogen are formed at a region in which silicon must be prevented from being deposited in the closed container 1, such as a gap between the reaction vessel 11 and a raw gas supply pipe 5, a region on the peripheral side of the reaction vessel 11, and the bottom end portion 11a of the reaction vessel 11, in such a manner that the region is filled with a sealing gas atmosphere.
Patent document 1: Japanese Laid-Open Patent Publication No. 2003-2627
Patent document 2: Japanese Laid-Open Patent Publication No. 2002-29726

### DISCLOSURE OF THE INVENTION

### PROBLEMS TO BE SOLVED BY THE INVENTION

However, in such a conventional reaction apparatus, even in the case in which a sealing gas is supplied to a region on the peripheral side of the reaction vessel 11 in which an apparatus for heating the bottom end portion 11a of the reaction vessel 11, a heat insulating material or the like is disposed, and the bottom end portion 11a of the reaction vessel 11, it is difficult to completely prevent a silicon deposition in such regions under the long-time operation of the apparatus. Consequently, in a conventional reaction apparatus, it is preferable to use the special member or configuration for the device and members that are disposed in such regions in consideration of a silicon deposition from a view point of a reaction continuation.

Moreover, in a conventional reaction apparatus, a large amount of gases has been required for filling the above regions with a sealing gas.
The present invention was made in order to solve the above problems of the prior art. An object of the present invention is to provide a silicon manufacturing apparatus capable of suppressing a silicon deposition to the bottom end portion of the reaction vessel and to a section other than the inside face of the reaction vessel except for the bottom end portion, thereby enabling a stable operation for a long time.

Another object of the present invention is to provide a silicon manufacturing apparatus capable of suppressing a silicon deposition to the bottom end portion of the reaction vessel and to a section other than the inside face of the reaction vessel except for the bottom end portion by using a small amount of supply gases.

### MEANS FOR SOLVING THE PROBLEMS

A silicon manufacturing apparatus related to the present invention comprising a tubular reaction vessel and a means for heating a reaction region including at least a bottom end portion of the reaction vessel to at least a melting point of silicon, wherein the chlorosilanes and hydrogen are supplied to the reaction vessel from a gas supply pipe installed on the upper side of the reaction vessel, silicon is deposited to the inside wall of the reaction vessel that has been heated, and the deposited silicon is withdrawn from an opening at the bottom end portion of the reaction vessel, is characterized by further comprising:
a first gas supply port that is formed by a circular slit and that supplies a sealing gas and/or an etching gas to the bottom end portion, on the peripheral side around the bottom end portion of the reaction vessel, and
a second gas supply port that supplies a sealing gas and/or an etching gas to a wall face of the member forming the first gas supply port at the outside periphery of the first gas supply port, at the position separate from the first gas supply port.

In a preferable embodiment related to the present invention, the first gas supply port is formed by a gap between the peripheral face of the reaction vessel and the inner circumferential face of a circular member formed adjacently to the peripheral side of the reaction vessel, and the second gas supply port supplies a sealing gas and/or an etching gas to a wall face of the circular member at the outside periphery of the first gas supply port.
More specifically, for instance, the second gas supply port supplies a sealing gas and/or an etching gas to the bottom face or the inner circumferential face of the circular member at the outside periphery of the first gas supply port.

In the above invention, for instance, a region on the peripheral side of the reaction vessel, in which a heat insulating member that is wound around the reaction vessel and a heating apparatus for heating the bottom end portion of the reaction vessel or the like are disposed, is isolated by a circular member or the like, and a sealing gas or the like is supplied to the bottom end portion of the reaction vessel through a circular slit formed along the periphery around the bottom end portion of the reaction vessel.
By the above configuration, a silicon deposition can be suppressed to a region on the peripheral side of the reaction vessel and the bottom end portion of the reaction vessel, and moreover a silicon deposition can be suppressed to the above regions by using a small amount of supply gases.

Consequently, it is unnecessary to use the special member or configuration for taking measures against a silicon deposition for the member and device that are disposed in the region on the peripheral side of the reaction vessel.
Moreover, in the above invention, the second gas supply port is formed at the position separate from the first gas supply port in such a manner that a sealing gas is supplied to a wall face of the member forming the first gas supply port at the outside periphery of the first gas supply port.

Since the first gas supply port for supplying a sealing gas or the like to the bottom end portion of the reaction vessel to suppress a silicon deposition at the bottom end portion of the reaction vessel is formed along the periphery of the bottom end portion of the reaction vessel, silicon is deposited with time to the wall face of the member that is disposed on the peripheral side of the reaction vessel and that forms the slit of the first gas supply port, for instance, to the bottom face or the inner circumferential face of the circular member at the outside periphery of the first gas supply port.

More specifically, since the wall face of the above member at the outside periphery of the first gas supply port is close to the bottom end portion of the reaction vessel, the wall face is heated up to a high temperature by a radiation heat or the like from the reaction vessel, thereby depositing silicon by a reaction gas from the inside of the reaction vessel.
However, in the present invention, since a sealing gas or the like is supplied from the second gas supply port to a wall face of the above member at the outside periphery of the first gas supply port, a silicon deposition to a wall face of the member forming the first gas supply port can be suppressed. Consequently, a shape of the first gas supply port can be maintained for a long time, and a sealing gas or the like is not prevented from being supplied to the bottom end portion of the reaction vessel from the first gas supply port in that time.

As described above, according to the apparatus related to the present invention forming the above first and second gas supply ports, there can be sufficiently suppressed a silicon deposition to the bottom end portion of the reaction vessel and to a section other than the inside face of the reaction vessel except for the bottom end portion, thereby enabling a stable operation for a long time.
Moreover, it is also possible to provide an action for further suppressing a silicon deposition to the bottom end portion of the reaction vessel or the like by a sealing gas or the like from the second gas supply port.

Furthermore, by forming the above second gas supply port, even in the case in which a supply amount per hour of a sealing gas or the like is further reduced as a total amount of a supply amount of a sealing gas or the like from the first gas supply port and a supply amount of a sealing gas or the like from the second gas supply port, a silicon deposition to the bottom end portion of the reaction vessel can be sufficiently suppressed, thereby enabling a stable operation for a long time by using a small amount of supply gases.

For instance, although it is difficult in practice to dispose the members for forming a slit in such a manner that a slit width of the first gas supply port is sufficiently small while scaling up a manufacturing apparatus, the second gas supply port can be sufficiently thin in such a manner that a sealing gas or the like can be supplied at a sufficient linear velocity by a small amount of a gas. Consequently, even in the case in which a supply amount per hour of a sealing gas or the like is further reduced as a total amount of a supply amount of a sealing gas or the like from the first gas supply port and a supply amount of a sealing gas or the like from the second gas supply port, a silicon deposition to the bottom end portion of the reaction vessel can be sufficiently suppressed, thereby enabling a stable operation for a long time by using a small amount of supply gases.

In some cases, a sealing gas or the like from the first gas supply port can be supplied to a degree in which a reverse flow of a gas from the lower section of the slit can be prevented, and it is not necessary to flow the sealing gas or the like to the bottom end portion of the reaction vessel.
In the present invention, it is preferable to supply an etching gas from the first gas supply port, the second gas supply port, or the both ports. Here, an etching gas can be used together with a sealing gas. In this case, a mixed gas of an etching gas and a sealing gas can be supplied, and a supply of an etching gas and a supply of a sealing gas can be switched by time. By using an etching gas, a silicon deposition can be sufficiently prevented with an extremely small amount of supply gases.

### EFFECT OF THE INVENTION

According to the silicon manufacturing apparatus related to the present invention, there can be sufficiently suppressed a silicon deposition to the bottom end portion of the reaction vessel and to a section other than the inside face of the reaction vessel except for the reaction vessel, thereby enabling a stable operation for a long time.
In addition, according to the silicon manufacturing apparatus related to the present invention, there can be sufficiently suppressed a silicon deposition to the bottom end portion of the reaction vessel and to a section other than the inside face of the reaction vessel except for the bottom end portion by using a small amount of supply gases.

### BRIEF DESCRIPTION OF THE DRAWINGS

Fig. 1 (a) is a cross-sectional view showing a section around a bottom end portion of a reaction vessel of a silicon manufacturing apparatus related to an embodiment of the present invention. Fig. 1(b) is a cross-sectional view showing a configuration along the A - A line of Fig. 1(a).
Fig. 2 is a cross-sectional view showing a section around a bottom end portion of a reaction vessel of a silicon manufacturing apparatus related to another embodiment of the present invention.
Fig. 3 is a cross-sectional view showing a section around a bottom end portion of a reaction vessel of a silicon manufacturing apparatus related to another embodiment of the present invention.
Fig. 4 is a cross-sectional view showing a specific example of the first and second gas supply ports.
Fig. 5 is a cross-sectional view showing a specific example of the first and second gas supply ports.
Fig. 6 is a cross-sectional view showing a specific example of the first and second gas supply ports.
Fig. 7 is a cross-sectional view showing a specific example of a shape of an inner circumferential side of a circular member.
Fig. 8 is a cross-sectional view showing a schematic configuration of a silicon manufacturing apparatus related to an embodiment of the present invention.
Fig. 9 is a cross-sectional view showing a schematic configuration of a conventional silicon manufacturing apparatus.

### EXPLANATIONS OF LETTERS OR NUMERALS

- 1:: closed container
- 2:: sealing gas supply port
- 3:: gas exhaust port
- 4:: upper space
- 5:: raw gas supply pipe
- 6:: raw gas supply port
- 7:: cooling medium supply port
- 8:: cooling medium exhaust port
- 11:: reaction vessel
- 11a:: bottom end portion
- 12:: sealing gas supply port
- 15:: high frequency heating coil
- 16a, 16b:: cooling jacket
- 17a, 17b:: cooling medium supply port
- 18a, 18b:: cooling medium exhaust port
- 21:: cooling recovery chamber
- 22:: cooling gas supply port
- 23:: silicon ejecting port
- 24:: recovery silicon
- 31:: first gas supply port
- 32:: circular member
- 32a:: lower face
- 32b:: inner circumferential face
- 33:: second gas supply port
- 34:: ring member
- 35:: cylindrical member
- 36:: heat insulating member
- 37:: flow of a sealing gas
- 38:: flow of a sealing gas
- 39:: bottom plate
- 40:: member for forming the second gas supply port
- 41:: gas supply port
- 42:: minute hole
- 43:: minute hole
- 51a:: inside member
- 51b:: outside member
- 52:: gas passage hole

### BEST MODE FOR CARRYING OUT THE INVENTION

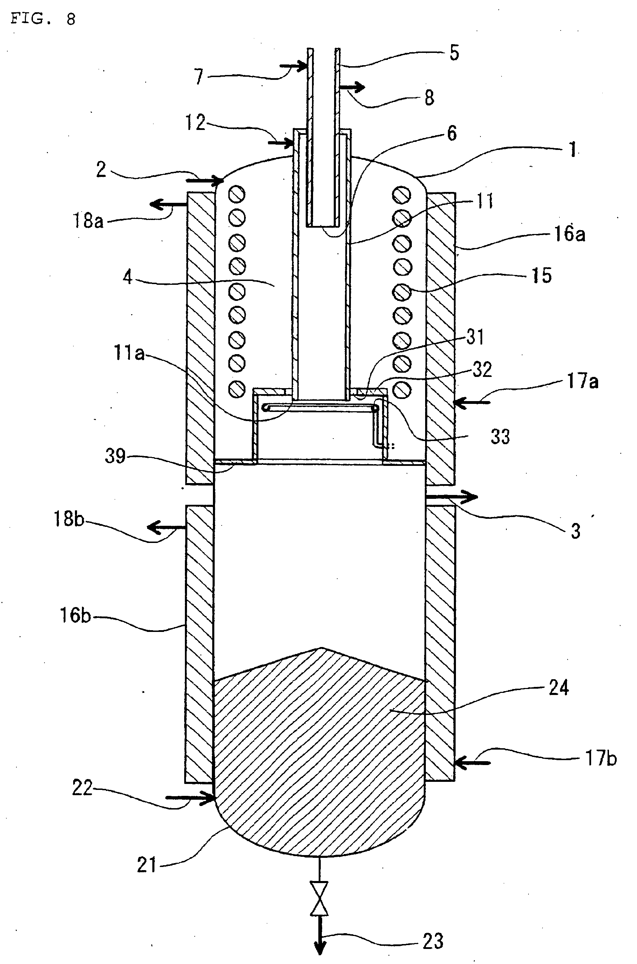

An embodiment (example) of the present invention will be described below in detail with reference to the drawings. Fig. 8 is a cross-sectional view showing a silicon manufacturing apparatus related to an embodiment of the present invention. Here, elements equivalent to those of a conventional silicon manufacturing apparatus illustrated in Fig. 9 are numerically numbered similarly. As shown in the figure, the silicon manufacturing apparatus related to the present embodiment is provided with a tubular reaction vessel 11 in a closed container 1. By supplying the chlorosilanes from a raw gas supply port 6 disposed on an upper side of the reaction vessel 11, silicon is deposited on the inside wall of the reaction vessel 11 that has been heated by a high frequency heating coil 15.

As the chlorosilanes that are used for a reaction, there are mentioned, for instance, trichlorosilane (SiHCl₃, hereafter referred to as TCS) and silicon tetrachloride (SiCl₄, hereafter referred to as STC). In addition, there can be preferably used the chlorodisilanes such as dichlorosilane (SiH₂Cl₂), monochlorosilane (SiH₃Cl), and hexachlorodisilane (Si₂Cl₆), and the chlorotrisilanes such as octachlorotrisilane (Si₃Cl₈) . While such the chlorosilanes can be individually used, at least two kinds of chlorosilanes can also be combined to be used.

Among the above chlorosilanes, by using chlorosilane mainly composed of TCS or STC, an occurrence of a silicon fine powder affecting a gas downstream area and of the high boiling silanes (polymer) having an ignition property can be reduced, thereby enabling a stable operation for a long time.
Hydrogen that is supplied for a deposition reaction together with the chlorosilanes is supplied from, for instance, a raw gas supply port 6 or a sealing gas supply port 12. As another means, hydrogen can also be supplied by connecting a supply pipe separate from a supply pipe for the chlorosilanes to a suitable position of the reaction vessel 11.

The reaction vessel 11 is formed cylindrically for instance, and is disengaged downward from an opening of the bottom end portion 11a. As a material forming the reaction vessel 11, there is preferably used a carbon material such as graphite, which can be heated by a high frequency and has a resistance at a melting point of silicon.
Moreover, it is preferable to coat an inside face of the pipe that directly comes into contact with deposited silicon with a material having a comparatively high resistance against a silicon molten solvent, such as silicon nitride, silicon carbide, and pyrolytic carbon, since a durability of the reaction vessel 11 and a purity of a silicon product can be improved.

While a cross sectional shape of the reaction vessel 11 is preferably circular, it can also be another shape such as a polygon. While the reaction vessel 11 is in a cylindrical shape in which a cross sectional area of each part is equivalent to each other, a cross section of a part can also be larger than other cross sections in such a manner that a staying time of a raw gas is lengthened, thereby improving a conversion rate to the chlorosilanes.
A shape of an opening at the bottom end portion 11a of the reaction vessel 11 can be straight downward in such a manner that a thickness of the pipe is uniform, or be tapered to form a reduced portion in such a manner that a diameter at a lower section is smaller. A peripheral edge of the opening can be horizontal, inclined, or in a wave shape. By such a configuration, a silicon droplet can be easily dropped from the peripheral edge of the opening, a droplet of a silicon molten solvent can be uniformed, and a grain diameter of a silicon grain can be uniformly adjusted to be smaller.

A raw gas supply pipe 5 is disposed at the upper section of the reaction vessel 11, and for instance the chlorosilanes and hydrogen are simultaneously or separately supplied from a raw gas supply port 6 thereof. The raw gas supply pipe 5 is preferably provided with a cooling means for cooling the raw gas supply pipe 5 in order to prevent a heat deterioration of the pipe and a thermal decomposition of the chlorosilanes in the pipe. As a cooling means, for instance, as shown in the figure, there are mentioned a liquid jacket method in which a passage from a cooling medium supply port 7 for supplying cooling medium liquid such as water and thermal oil to a cooling medium exhaust port 8 is disposed in the raw gas supply pipe 5 for cooling, and a air cooling jacket method in which the raw gas supply pipe 5 is cooled by disposing one or at least two nozzles in an almost concentric circle shape on the periphery of the raw gas supply pipe 5 and by purging a cooling gas to a gap between the raw gas supply pipe 5 and each nozzle on the periphery of the raw gas supply pipe 5.

A cooling temperature of the raw gas supply pipe 5 can be set to less than a decomposition temperature of the chlorosilanes to be supplied. In the case in which TCS or STC is used as a raw material, a temperature in the pipe is preferably 800°C or less, more preferably 600°C or less, most preferably 500°C or less. As a material of the raw gas supply pipe 5, a quartz glass, iron, a stainless steel or the like can be used in addition to a material equivalent to that of the reaction vessel 11.

The sealing gas supply port 12 is formed to supply a sealing gas to a space in the reaction vessel 11 at the position higher than the opening position of the raw gas supply pipe 5. The gas supply pipe 5 is inserted into the reaction vessel 11 in such a manner that the chlorosilanes are directly supplied to a high-temperature space in the reaction vessel 11. This is carried out for preventing the chlorosilanes supplied to the reaction vessel 11 as a raw material from being deposited in a low-temperature region at the upper section of the reaction vessel 11. In this case, there is a temperature gradient from a melting temperature of silicon to less than a deposition temperature of silicon on the wall face at the position higher than the opening position of the raw gas supply pipe 5. In the case in which the chlorosilanes or a mixed gas of the chlorosilanes and hydrogen reaches this section, silicon is deposited and grown at the upper side from the position having a temperature at which silicon is deposited in a solid state, thereby causing a silicon manufacturing apparatus to be choked up during a long-time operation of the apparatus.

Against the above problem, by forming the sealing gas supply port 12 at the position higher than the opening position of the raw gas supply pipe 5, a space involving the above temperature gradient is filled with a sealing gas, thereby preventing the chlorosilanes or a mixed gas of the chlorosilanes and hydrogen from penetrating, in addition, effectively preventing solid silicon from being deposited.
In the case in which silicon is manufactured by a method in which the inside face of the reaction vessel 11 is heated up to a temperature less than a melting point of silicon at which silicon can be deposited to deposit silicon (second method described before), the raw gas supply port 6 shown in Fig. 8 is not formed in the reaction vessel 11 and can be formed above the upper face of the reaction vessel 11. In this case, a hydrogen gas can be separately supplied from a position around the upper face of the reaction vessel 11.

As a sealing gas, it is preferable to use a gas that does not generate silicon and that does not affect a generation of silicon in a region in which the chlorosilanes exist. More specifically, while hydrogen or an inert gas such as argon and helium can be used, hydrogen that is one of raw materials is preferable. In this case, a supply amount of a sealing gas is sufficient in the case in which a sealing gas is supplied up to a degree to maintain a pressure for always filling the space involving the above temperature gradient. In order to reduce a supply amount of a sealing gas, a shape of the reaction vessel 11 or a shape of an outside wall of the raw gas supply pipe 5 can be determined in such a manner that a cross sectional area of the entire or lower section of the space is reduced.

A part or the entire of hydrogen that is one of raw gases can be introduced from the sealing gas supply pipe 12 to the reaction system.
A sealing gas can also be supplied from a separate sealing gas supply port 12 disposed on the closed container to a region in which silicon must be prevented from being deposited in the closed container 1, such as a region outside the reaction vessel 11 and a region around the bottom end portion 11a of the reaction vessel 11.

The reaction vessel 11 is heated by an electromagnetic wave (a high frequency wave) emitted from the high frequency heating coil 15 disposed on the periphery thereof. An inside face of the reaction vessel 11 is heated up to a temperature equivalent to or higher than a melting point of silicon or a temperature less than that at which silicon can be deposited. In general, such a heated region is a region with a length in the range of 30 to 90% of the total length of the reaction vessel 11 in the closed container 1 upward from the bottom end portion 11a.
In the case in which the inside face of the reaction vessel 11 is heated up to a temperature equivalent to or higher than a melting point of silicon to deposit silicon (first method described before), the inside face of the reaction vessel 11 is heated up to a temperature equivalent to or higher than a melting point of silicon (approximately 1410 to 1430°C), and silicon is deposited in a molten state.

In the case in which the inside face of the reaction vessel 11 is heated up to a temperature less than a melting point of silicon at which silicon can be deposited to deposit silicon (second method described before), the inside face of the reaction vessel 11 is heated up to a temperature of preferably 950°C or higher, more preferably 1200°C or higher, further preferably 1300°C or higher to deposit silicon.
The high frequency heating coil 15 generates an electromagnetic wave to heat the reaction vessel 11 by energizing a coil from a power source (not shown). A frequency of the electromagnetic wave can be set to a proper value depending on a material or a shape of an object to be heated such as the reaction vessel 11, for instance, to a value in the range of several tens Hz to several tens GHz.

As a method of heating the reaction vessel 11 from the outside, there are mentioned a method using a heating wire and a method using infrared rays, in addition to a high frequency heating method.
Silicon that has been deposited on the inside face of the reaction vessel 11 is dropped from an opening at a bottom end portion 11a of the reaction vessel 11 and is recovered in a cooling recovery chamber 21 disposed in a dropping direction. In the first method described before, a molten silicon that has been deposited in a molten state is continuously dropped from an opening at a bottom end portion 11a of the reaction vessel 11 and is recovered in a cooling recovery section 21 disposed in a dropping direction. In this case, the molten silicons that has been deposited flows down along the inside face of the reaction vessel 11, freely drops as a droplet from the bottom end portion 11a, and is solidified during dropping or after dropping. Silicon dropped into the cooling recovery section 21 is cooled by a solid coolant such as silicon, copper, and molybdenum, a liquid coolant such as liquid silicon tetrachloride and liquid nitrogen, or a cooling gas supplied from a cooling gas supply port 22 formed in the cooling recovery section 21 if necessary.

In the second method described before, after silicon is deposited in a solid state on the inside face of the reaction vessel 11, the inside face is heated up to a temperature equivalent to or higher than a melting point of silicon, and the part or whole of a deposited substance is molten, dropped, and recovered in a cooling recovery chamber 21 disposed in a dropping direction.
As a material of the cooling recovery chamber 21, there can be used, for instance, a metal material, a ceramics material, and a glass material. In such a manner that high-purity silicon can be recovered as well as this apparatus can be made firm as an industrial apparatus, it is preferable to carry out lining to the inside of the metal recovery chamber by using silicon, Teflon (registered trademark), a quartz glass, tantalum, tungsten, molybdenum or the like. It is also possible to dispose silicon grains at the bottom of the cooling recovery chamber 21. After a reaction, an exhaust gas in the reaction vessel 11 is exhausted from a gas exhaust port 3.

If necessary, it is also possible to form an ejecting port 23 for ejecting solidified silicon continuously or intermittently from the cooling recovery chamber 21. Moreover, it is preferable to form a cooling jacket 16b on the cooling recovery chamber 21 in such a manner that silicon can be more effectively cooled. For cooling, cooling medium liquid such as water, thermal oil, and alcohol passes through the cooling jacket 16b.
The manufacturing conditions of the silicon manufacturing apparatus related to the present embodiment are not restricted. However, in order to more effectively prevent solid silicon from being deposited in the cooling recovery apparatus, it is preferable to determine a supply ratio, a supply amount, and a staying time of the chlorosilanes and hydrogen in such a manner that the chlorosilanes and hydrogen are supplied to the silicon manufacturing apparatus to generate silicon under the condition in which a conversion rate from the chlorosilanes to silicon is 20% or higher, preferably 30% or higher. In order to obtain a silicon manufacturing speed economical against a size of the reaction chamber, a molar fraction of the chlorosilanes in a supply gas is preferably in the range of 0. 1 to 99. 9 mol%, more preferably in the range of 5 to 50 mol%. While a higher reaction pressure has an advantage of miniaturizing an apparatus, a pressure of 0 to 1 MPaG can be easily implemented industrially.

While a staying time of a gas changes depending on the conditions of a pressure and a temperature to a reaction chamber having a constant capacity, an average staying time of a gas in the reaction vessel 11 can be set to 0.001 to 60 seconds, preferably 0.01 to 10 seconds under the reaction condition, thereby enabling a sufficiently economical conversion rate of the chlorosilanes to be obtained.
In the present embodiment, a circular member 32 is disposed on the peripheral side of the reaction vessel 11, and a sealing gas is supplied to the bottom end portion 11a of the reaction vessel 11 through a first gas supply port 31 composed of a circular slit formed between the inner circumferential face of the circular member 32 and the peripheral face of the reaction vessel 11.

A second gas supply port 33 formed by a separate member is disposed below the circular member 32, and a sealing gas is supplied to the bottom face of the circular member 32 from the second gas supply port 33.
An upper space 4 of the circular member 32 is partitioned by a bottom plate 39, and is isolated from a space in which a reaction gas such as the chlorosilanes flows in the closed container 1. In the upper space 4, there are installed if necessary many kinds of members and apparatuses such as a heat insulating member for maintaining a temperature of the reaction vessel 11 (not shown) in addition to an apparatus for heating the reaction vessel 11 such as the high frequency heating coil 15.

As described above, in the present invention, a region on the peripheral side of the reaction vessel is isolated by the circular member or the like, and a sealing gas is supplied to the bottom end portion of the reaction vessel through a circular slit formed along the periphery around the bottom end portion of the reaction vessel.
By the above configuration, a silicon deposition can be suppressed to a region on the peripheral side of the reaction vessel and the bottom end portion of the reaction vessel, and moreover a silicon deposition can be suppressed to the above regions by using a small amount of supply gases.

Moreover, the second gas supply port is formed at the position separate from the first gas supply port in such a manner that a sealing gas is supplied to a wall face of the member forming the first gas supply port at the outside periphery of the first gas supply port.
Since the first gas supply port for supplying a sealing gas or the like to the bottom end portion of the reaction vessel to suppress a silicon deposition at the bottom end portion of the reaction vessel is formed along the periphery of the bottom end portion of the reaction vessel, silicon is deposited with time to the wall face of the member that is disposed on the peripheral side of the reaction vessel and that forms the slit of the first gas supply port.

More specifically, since the wall face of the above member at the outside periphery of the first gas supply port is close to the bottom end portion of the reaction vessel, the wall face is heated up to a high temperature by a radiation heat or the like from the reaction vessel, thereby depositing silicon by a reaction gas from the inside of the reaction vessel.
However, in the present invention, since a gas is supplied from the second gas supply port to the above section of the first gas supply port, a silicon deposition to the above section can be effectively prevented. In addition, although a radiation heat from the reaction vessel is applied to the second gas supply port, the second gas supply port is not closer to the reaction vessel as compared with the first gas supply port. Therefore, it is hard to heat the second gas supply port to a high temperature in which a silicon deposition is a trouble. Consequently, a function and a shape of the second gas supply port are maintained for a long time, thereby also maintaining a shape of the first gas supply port to which a high-temperature heat is applied. As a result, a silicon deposition to the bottom end portion of the reaction vessel can be prevented for a long time.

As described above, according to the present invention forming the above first and second gas supply ports, there can be sufficiently suppressed a silicon deposition to the bottom end portion of the reaction vessel and to a section other than the inside face of the reaction vessel except for the bottom end portion, thereby enabling a stable operation for a long time.
An etching gas that can react with a generated solid silicon or a mixed gas of a sealing gas and an etching gas can be continuously or intermittently supplied from the first gas supply port, the second gas supply port, or the both ports.

As an etching gas that can react to silicon, there are mentioned for instance hydrogen chloride (HC1), chlorine (C1₂), and silicon tetrachloride. Hydrogen chloride is diluted by a hydrogen gas for instance, is introduced into the reaction system at a hydrogen chloride concentration of preferably 0.01 to 100 vol%, and converts solid silicon (Si) to a gas (SiHCl₃) based on the typical reaction: Si + 3HCl → SiHCl₃ + H₂. In addition, solid silicon (Si) can also be converted to SiCl₄, SiH₂Cl₂ and so on. In order to progress such reactions smoothly, a concentration of hydrogen chloride in a gas atmosphere in the reaction system is maintained in such a manner that an etching speed is higher than a deposition speed of silicon.

In the case in which silicon tetrachloride (SiCl₄) is mixed to hydrogen, a speed of a deposition reaction is higher when a mole ratio of hydrogen is large, and a speed of an etching reaction is higher when a mole ratio of hydrogen is small on the other hand. Since the value thereof changes depending on a reaction temperature, it is preferable to specify a temperature and a concentration depending on a purpose. In the case in which an etching has priority over a deposition, at a reaction temperature of 1400°C, silicon tetrachloride is diluted by a hydrogen gas for instance, is introduced into the reaction system as a mixed gas of a silicon tetrachloride concentration of preferably 30 to 50 vol%, and converts silicon to a gas similarly based on the typical reaction: Si + 3SiCl₄ + 2H₂ → 4SiHCl₃. In addition, solid silicon (Si) can also be converted to SiCl₄, SiH₂Cl₂ and so on. In this case, in order to progress such reactions smoothly, a concentration of silicon tetrachloride is maintained in such a manner that an etching speed is higher than a deposition speed of silicon.

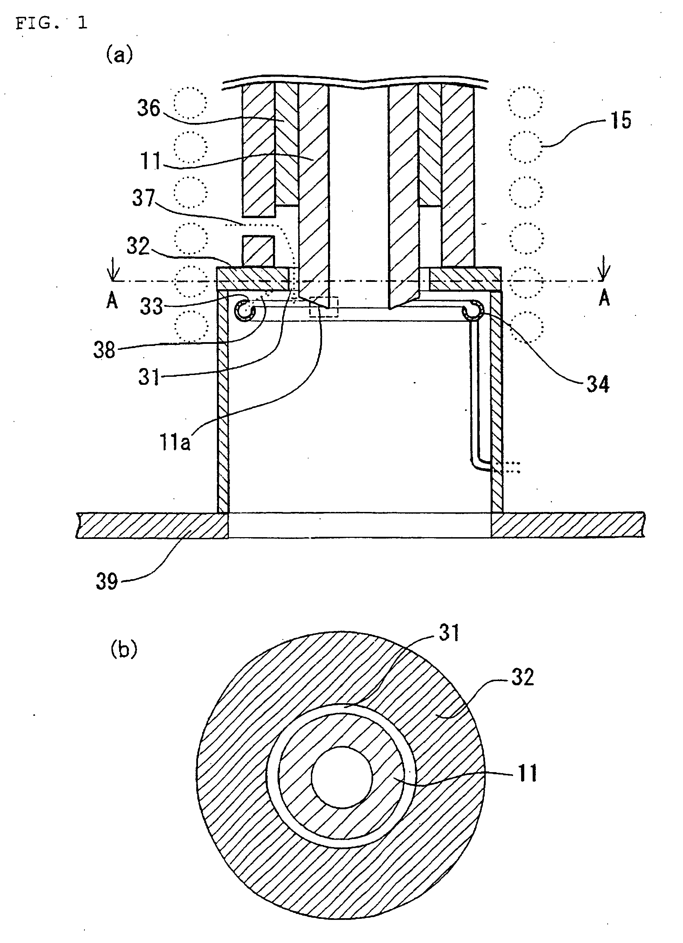

By using an etching gas, an amount of a gas for preventing a silicon deposition at the bottom end portion of the reaction vessel can be further reduced
The following describes the first and second gas supply ports of the silicon manufacturing apparatus related to the present invention based on a specific embodiment. Fig. 1(a) is a cross-sectional view showing a section around a bottom end portion of a reaction vessel of a silicon manufacturing apparatus related to an embodiment of the present invention, and Fig. 1 (b) is a cross-sectional view showing a configuration along the A - A line of Fig. 1(a). As shown in the figure, a circular member 32 is disposed on the peripheral side of the reaction vessel 11, and the peripheral region of the reaction vessel 11, in which a heat insulating member 36 and a high frequency heating coil 15 are installed, is isolated from a space thereunder by the circular member 32 and a bottom plate 39.

A sealing gas 37 is supplied to a bottom end portion 11a of the reaction vessel 11 through a first gas supply port 31 composed of a circular slit formed between the inner circumferential face of the circular member 32 and the peripheral face of the reaction vessel 11.
Here, the bottom end portion 11a of the reaction vessel 11 indicates the surface of the pipe in the region enclosed by the dashed line in the figure.

A ring member 34 is disposed below the circular member 32. The ring member 34 is provided with a circular second gas supply port 33, and a gas supply pipe or the like connected to an external apparatus or the like is attached to the ring member 34. A sealing gas 38 is supplied to the bottom face of the circular member 32 from the second gas supply port 33 of the ring member 34, thereby suppressing a silicon deposition to the bottom face of the circular member 32.

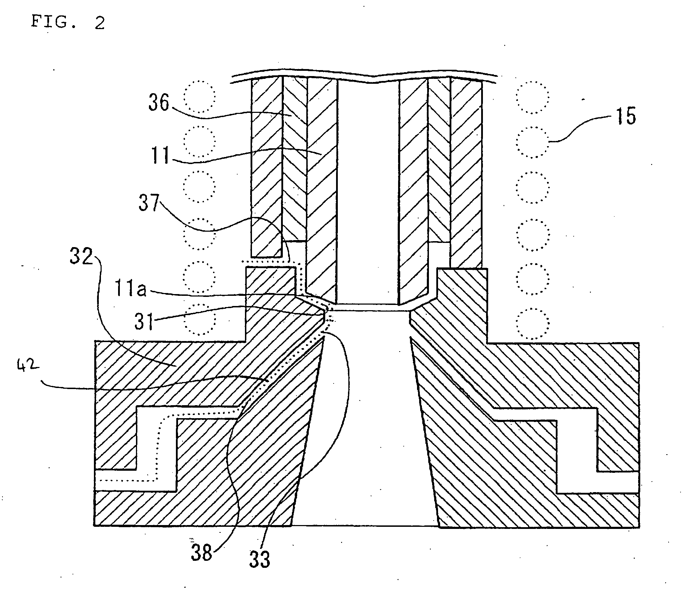

Fig. 2 is a cross-sectional view showing a section around a bottom end portion of a reaction vessel of a silicon manufacturing apparatus related to another embodiment of the present invention. As shown in the figure, a circular member 32 is disposed on the peripheral side of the reaction vessel 11, and the peripheral region of the reaction vessel 11, in which a heat insulating member 36 and a high frequency heating coil 15 are installed, is isolated from a space thereunder by the circular member 32 or the like.

A sealing gas 37 is supplied to a bottom end portion 11a of the reaction vessel 11 through a first gas supply port 31 composed of a circular slit formed between the inner circumferential face of the circular member 32 and the peripheral face of the reaction vessel 11.
Many minute holes 42 are formed in the circular member 32, and the outlets of the minute holes 42 are disposed along a circumference on the inner circumferential face of the circular member 32. A second gas supply port 33 is formed by the minute holes 42. A sealing gas 38 is supplied from the second gas supply port 33 to a wall face of the circular member 32 at the outside periphery of the first gas supply port 31 (the inner circumferential face on the upper side of the outlets of the minute holes 42), thereby suppressing a silicon deposition to the wall face.

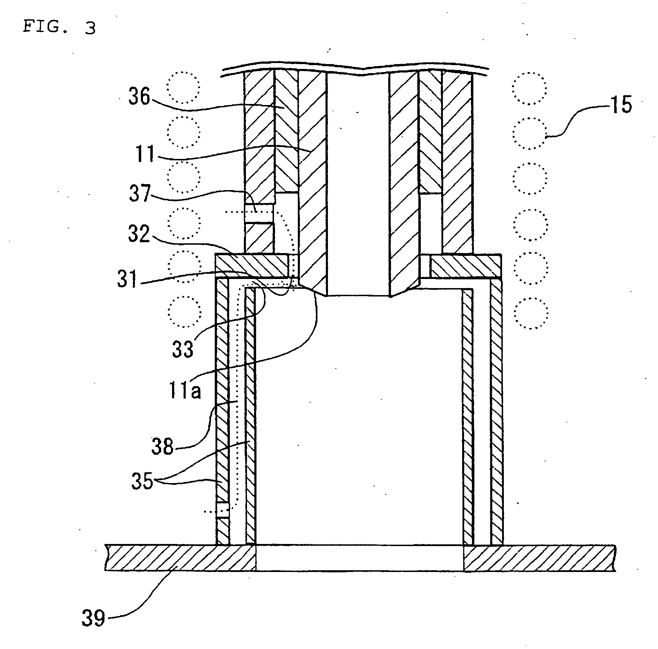

Fig. 3 is a cross-sectional view showing a section around a bottom end portion of a reaction vessel of a silicon manufacturing apparatus related to another embodiment of the present invention. As shown in the figure, a circular member 32 is disposed on the peripheral side of the reaction vessel 11, and the peripheral region of the reaction vessel 11, in which a heat insulating member 36 and a high frequency heating coil 15 are installed, is isolated from a space thereunder by the circular member 32 and a bottom plate 39.
A sealing gas 37 is supplied to a bottom end portion 11a of the reaction vessel 11 through a first gas supply port 31 composed of a circular slit formed between the inner circumferential face of the circular member 32 and the peripheral face of the reaction vessel 11.

A second gas supply port 33 that is a circular gap formed by a cylindrical member 35 is formed below the circular member 32, and a sealing gas 38 is supplied to the bottom face of the circular member 32 from the second gas supply port 33, thereby suppressing a silicon deposition to the bottom face of the circular member 32.
In the present invention, in the case in which the circular member has a structure for forming the first gas supply port in a slit shape between the circular member and the reaction vessel, a shape of the circular member is not restricted in particular. As a material for forming the circular member, there are mentioned for instance a quartz glass and a ceramics material containing silicon nitride, silicon carbide, aluminum oxide, or zirconium oxide.

It is preferable to dispose the circular member in such a manner that the outlet of the first gas supply port is located around the bottom end portion of the reaction vessel. In the case in which the outlet of the first gas supply port is much higher than the bottom end portion of the reaction vessel 11, a large amount of a sealing gas may be required for preventing a silicon deposition to the bottom end portion of the reaction vessel by a sealing gas from the first gas supply port.
The circular member is preferably disposed in such a manner that the position of the outlet of the first gas supply port is in the range of 0 to 100 mm upward from the bottom end portion of the reaction vessel in order to effectively prevent a silicon deposition to the bottom end portion of the reaction vessel. A width of the first gas supply port is, for instance, in the range of 2.5 to 25 mm.

A linear velocity of a sealing gas, an etching gas, and a mixed gas thereof from the first gas supply port is preferably at least 0.05 m/s. For a sealing gas from the sealing gas supply port 12 shown in Fig. 8, in the case in which a flow rate of the chlorosilanes or the like as a raw gas is large, a turbulence occurs in a flow of a sealing gas, thereby preventing a sufficient sealing effect from being obtained depending on a linear velocity of a sealing gas. However, for a sealing gas from the first gas supply port 31, even in the case in which a flow rate of the chlorosilanes or the like as a raw gas is large, a sufficient sealing effect can be obtained at a small linear velocity.

By supplying a sealing gas from the second gas supply port to the bottom end portion of the reaction vessel, a silicon deposition to the bottom end portion of the reaction vessel can also be simultaneously suppressed. In this case, a flow direction of a sealing gas from the second gas supply port is preferably oriented to the bottom end portion of the reaction vessel.
In the case in which a gas is supplied to the bottom face of the circular member as shown in Fig. 1 or 3, the second gas supply port is preferably disposed in such a manner that the position of the second gas supply port is in the range of 0 to 200 mm downward from the bottom end portion of the reaction vessel in order to effectively suppress a silicon deposition to the bottom face of the circular member and effectively prevent a silicon deposition to the bottom end portion of the reaction vessel.

The second gas supply port can be formed to have a width in the range of 1 to 10 mm for instance, and can be sufficiently thin in such a manner that a sealing gas can be supplied at a sufficient linear velocity by a small amount of a gas. Consequently, even in the case in which a supply amount of a sealing gas per hour is extremely reduced as compared with a conventional method, as a total amount of a supply amount of a sealing gas from the second gas supply port and a supply amount of a sealing gas from the first gas supply port, a silicon deposition to the bottom end portion of the reaction vessel can be sufficiently suppressed.

In the present invention, a mode for making a sealing gas and/or an etching gas from the second gas supply port come into contact with a wall face of the circular member at the outside periphery of the first gas supply port can be implemented by a natural convection of the gas or by a blow of the gas to the wall face.

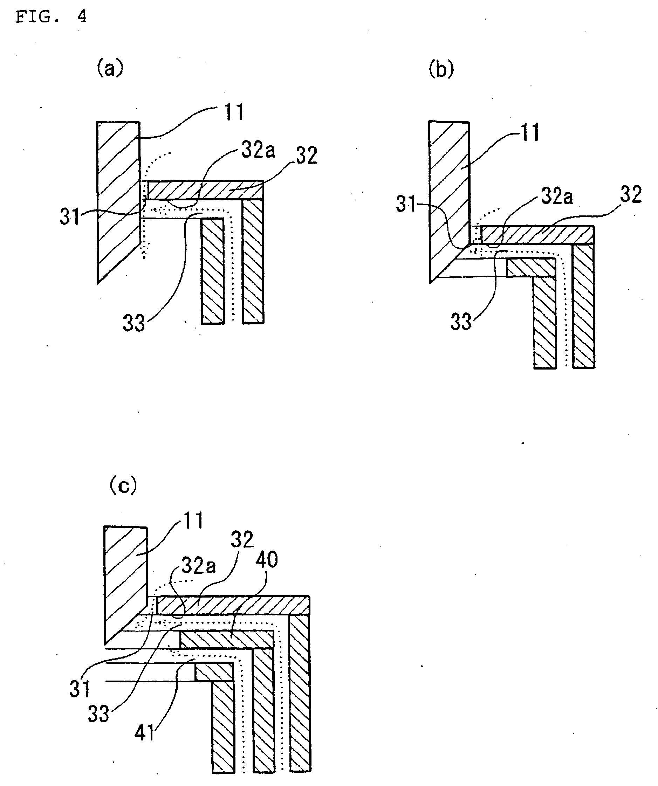

Figs. 4 to 6 are cross-sectional views showing specific examples of the first and second gas supply ports. In the figures, a section around the bottom end portion of the reaction vessel 11 is only shown by one side cross section, and a flow of a sealing gas and/or an etching gas (hereafter referred to as a sealing gas or the like) is shown by a dotted line arrow. In Figs. 4(a) to 4(c), a circular second gas supply port 33 is formed below the circular member 32 similarly to Fig. 3, and a sealing gas or the like is supplied to the bottom face 32a of the circular member 32. In the case in which the lower member forming the second gas supply port 33 is heated up to a high temperature by a radiation heat or the like from the bottom end portion 11a of the reaction vessel 11, and silicon may be deposited to the member, as shown in Fig. 4(c), a gas supply port 41 can be further formed below a member 40 forming the second gas supply port 33, and a sealing gas or the like can be supplied to the outside periphery of the second gas supply port 33 of the member 40.

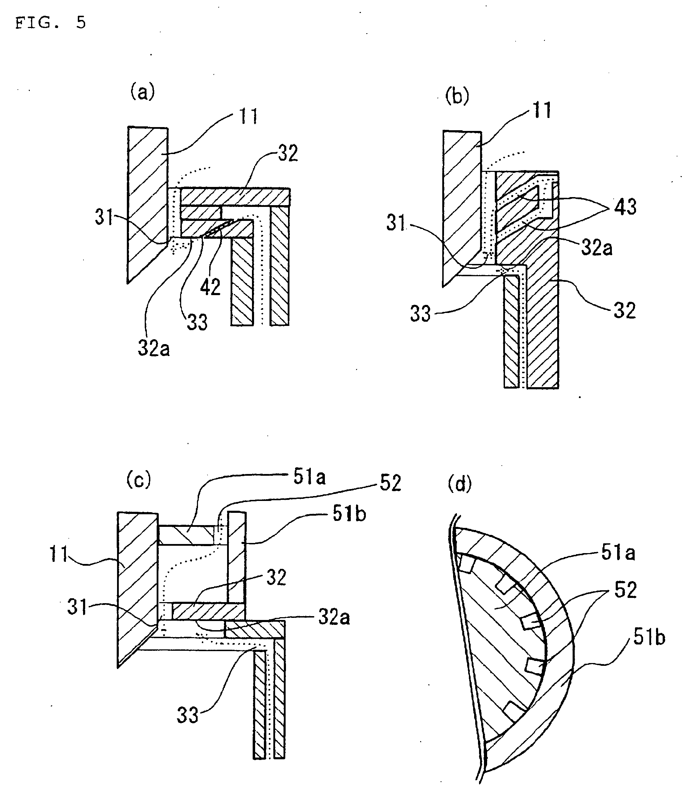

In Fig. 5 (a), many minute holes 42 are formed in the circular member 32, and the outlets of the minute holes 42 are disposed along a circumference on the bottom face of the circular member 32. A second gas supply port 33 is formed by the minute holes 42, and a sealing gas or the like is supplied from the second gas supply port 33 to the bottom face 32a of the circular member 32.
In Fig. 5(b), a sealing gas or the like is supplied from an upper section to a slit formed by a gap between the reaction vessel 11 and the circular member 32. In addition, the outlets of many minute holes 43 in the circular member 32 are disposed along a circumference in a multistage pattern on the inner circumferential face of the circular member 32. A sealing gas or the like is also supplied from the minute holes 43 and is blown from the outlet of the first gas supply port 31. A circular second gas supply port 33 is formed below the circular member 32, and a sealing gas or the like is supplied to the bottom face 32a of the circular member 32.

In Fig. 5(c), a sealing gas is supplied to the first gas supply port 31 through a gas passage hole 52 formed by an inside member 51a and an outside member 51b. Fig. 5(d) is a partially cross-sectional view in a horizontal direction showing these members. As shown in the figure, the gas passage holes 52 are formed between many concaves formed at a specified pitch on the periphery of the inside member 51a and the inner circumferential face of the outside member 51b. The outside member 51b can move together with the circular member 32 depending on a movement of the reaction vessel 11. The outside member 51b and the circular member 32 can be fixed to each other, or can be formed by the same member in an integrating manner.

In the case in which an a manufacturing apparatus is scaled up, the reaction vessel 11 is lengthened, and a misalignment may occur between the reaction vessel 11 and the circular member 32 around the bottom end portion of the reaction vessel 11. In this case, a slit width between the reaction vessel 11 and the circular member 32 is not uniform, and the reaction vessel 11 and the circular member 32 may come into contact with each other in some cases. As described above, in the case in which the slit width is not uniform, a desired performance caused by forming the first gas supply port may be deteriorated.

In such a case, as shown in Fig. 5(c), the outside member 51b is fixed to the circular member 32, and the inside member 51a is interposed between the reaction vessel 11 and the outside member 51b, thereby maintaining a slit width between the reaction vessel 11 and the circular member 32 to be always uniform. More specifically, a centering function for making the centers of the reaction vessel 11 and the circular member 32 to conform with each other can be obtained by the inside member 51a and the outside member 51b.

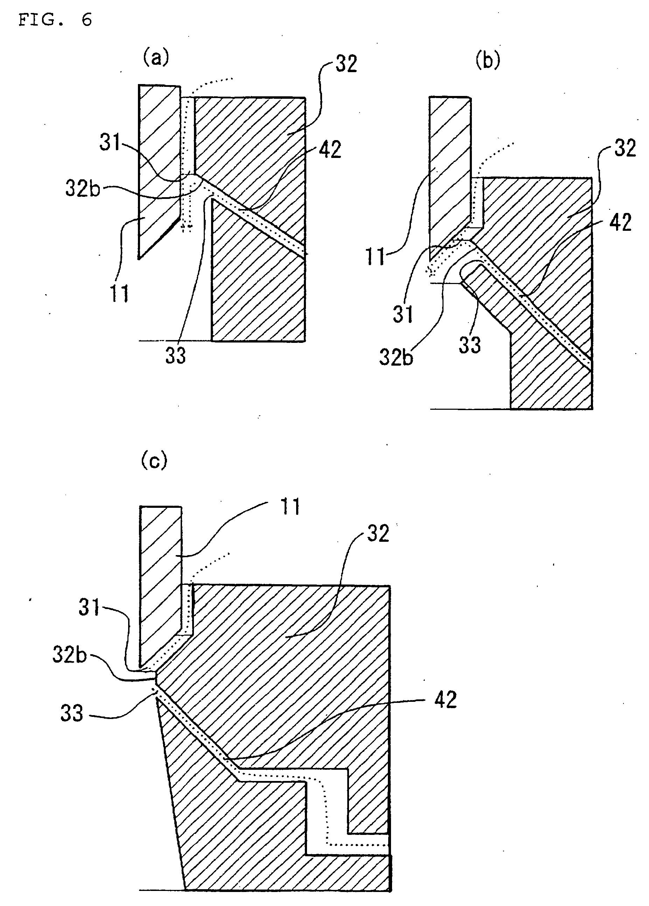

In Figs. 6(a) to 6(c), many minute holes 42 are formed in the circular member 32, and the outlets of the minute holes 42 are disposed along a circumference on the inner circumferential face of the circular member 32. A second gas supply port 33 is formed by the outlets of the minute holes 42, and a sealing gas or the like is supplied from the second gas supply port 33 to the inner circumferential face 32b of the circular member 32 at the outside periphery of the outlet of the first gas supply port 31 in a slit shape formed by a gap between the reaction vessel 11 and the circular member 32.

As shown in Figs. 6(a) to 6(c), in the case in which a sealing gas or the like that is sent from the second gas supply port 33 is supplied from the minute holes 42, slits can be formed along a circumference in which the outlets of the minute holes 42 are disposed, and the outlets of the minute holes 42 can be disposed on the concaves of the slits.
Moreover, a blowing direction of a sealing gas or the like from the outlets of the minute holes 42 can also be an inclined direction upward or downward in addition to a horizontal direction toward the center. In addition, a blowing direction of a sealing gas or the like can also be an inclined direction from a direction toward the center of the circular member 32 to the inner circumferential tangential line of the circular member 32 based on the outlet of the minute hole 42 as a cardinal point, that is, a direction along a circumference of the circular member 32.

As shown in Figs. 6(a) to 6(c), as a material forming the circular member 32 in which the second gas supply port 33 is formed by disposing the outlets of the minute holes 42 along a circumference, a ceramics perforated plate can be mentioned for instance in the case in which a heating means of the reaction vessel 11 is a heating method using an electromagnetic wave (the material differs depending on the heating means of the reaction vessel 11).

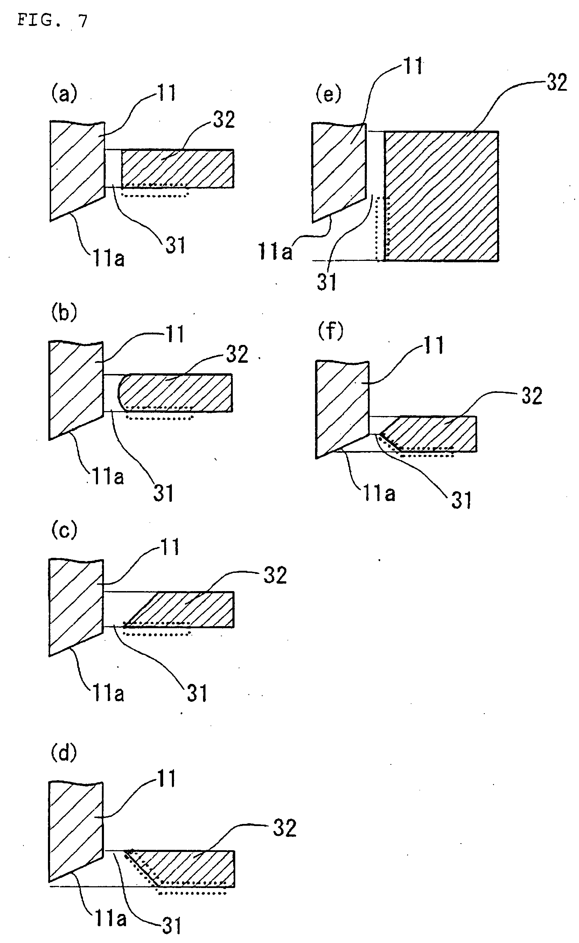

Fig. 7 is a view showing a specific example of an inner circumferential shape of the circular member. In the figure, the wall face at the position enclosed by a dotted line is a section in which a silicon deposition must be prevented by a sealing gas or the like from the second gas supply port. As shown in the figure, as a specific example of a cross sectional shape of an inner circumferential side of the circular member, there are mentioned a linear shape almost parallel to the peripheral face of the reaction vessel 11 as shown in Fig. 7(a), a curved face as shown in Fig. 7(b), a straight-sided shape sharpened with an angle as shown in Figs. 7(c) and 7(d), a long linear shape extending downward from the bottom end portion 11a of the reaction vessel 11 as shown in Fig. 7(e), and an angle cutting sharpened shape as shown in Fig. 7 (f). A relative position between the bottom end portion 11a of the reaction vessel 11 and the circular member 32 is not restricted to the figure, and can be properly arranged depending on cases.

### Examples

While the preferred examples of the present invention will be described in the following, the present invention is not restricted to the examples.

### (Examples 1 to 14)

A tubular reaction vessel 11 made of carbon with an outer diameter of 100 mm, an inner diameter of 70 mm, and a length of 1000 mm was installed to a polycrystalline silicon manufacturing apparatus (see Fig. 8). As shown in Fig. 3, a circular member 32 and a cylindrical member 35 were then installed. By the above configuration, a first gas supply port 31 was formed by a slit between the reaction vessel 11 and the circular member 32, and a second gas supply port 33 was formed by a circular gap between the bottom face of the circular member 32 and the cylindrical member 35. Here, silicon nitride ceramics was used as a material of the circular member 32 and the cylindrical member 35.

A mixed gas of trichlorosilane of 20 kg/H and hydrogen of 40 Nm³/H is flown in the reaction vessel 11, and the reaction vessel 11 was heated to 1450°C or higher by high frequency heating, thereby depositing polycrystalline silicon in a molten state. A reaction for 50 hours was carried out, and a surface state (an amount of silicon adhering) of the reaction vessel 11 directly over the circular member 32 was observed, thereby confirming a sealing effect. Table 1 shows the conditions of a dimension of a width of the first gas supply port 31 and the second gas supply port 33, a kind, a supply amount, and a linear velocity of a sealing gas, and a concentration of en etching gas (HCl), and a result of a surface state in each example.

A silicon adhesion to the bottom face of the circular member 32 was hardly observed in Examples 1 to 14.

### (Examples 15 to 19)

A continuous reaction was carried out under the conditions equivalent to those in Example 10 except for using a material shown in Table 2 as a material of the circular member 32 and the cylindrical member 35, and a surface state (an amount of silicon adhering) of the reaction vessel 11 was observed, thereby confirming a sealing effect. Table 2 shows the results.

A silicon adhesion to the bottom face of the circular member 32 was hardly observed in Examples 15 to 19.

### (Comparative example 1)

A continuous reaction was carried out under the conditions equivalent to those in Example 1 except that a second gas supply port was not formed and that a linear velocity of a nitrogen gas from the first gas supply port was 1.6 Nm/s. After the reaction, a surface state of the reaction vessel 11 directly over the circular member 32 was observed, thereby confirming a sealing effect. As a result, an amount of silicon adhering to the surface of the reaction vessel 11 was 0.1 mm/H.

In Comparative example 1, a considerable amount of silicon was adhered to the bottom face of the circular member 32 after the reaction, and a silicon deposition was confirmed.

### (Comparative example 2)

A continuous reaction was carried out under the conditions equivalent to those in Example 1 except that a circular member 32 and a cylindrical member 35 for forming a slit that was a first gas supply port 31 were not used and that a gap width of a peripheral side space of the reaction vessel 11 was 50 mm to blow a gas with a linear velocity of 5 Nm/S from the gap. After the reaction, a surface state of the reaction vessel 11 directly over the circular member 32 was observed, thereby confirming a sealing effect. As a result, an amount of silicon adhering to the surface of the reaction vessel 11 was 0.2 mm/H.

**Table 1**

| | Dimen sion of the first gas supply port (31) (mm) | Kind of a gas from the first gas supply port (31) | Linear velocity of a gas from the first gas supply port (31) (Nm/S) | HCl concentr ation in a gas from the first gas supply port (31) (vol%) | Dimen sion of the second gas supply port (33) (mm) | Kind of a gas from the second gas supply port (33) | Linear velocity of a gas from the second gas supply port (33) (Nm/S) | HCl concentr ation in a gas from the second gas supply port (33) (vol%) | Amount of silicon adhering to the reaction vessel 11 (mm/H) |
|---|---|---|---|---|---|---|---|---|---|
| Example 1 | 10 | Nitrogen | 0.16 | 0 | 2 | Hydrogen | 6.5 | 0 | 0.03 |
| Example 2 | 3.5 | Nitrogen | 0.16 | 0 | 2 | Hydrogen | 6.5 | 0 | 0.03 |
| Example 3 | 20 | Nitrogen | 0.16 | 0 | 2 | Hydrogen | 6.5 | 0 | 0.03 |
| Example 4 | 10 | Nitrogen | 0.05 | 0 | 2 | Hydrogen | 6.5 | 0 | 0.03 |
| Example 5 | 10 | Nitrogen | 0.5 | 0 | 2 | Hydrogen | 6.5 | 0 | 0.025 |
| Example 6 | 10 | Nitrogen | 0.16 | 0 | 2 | Hydrogen | 0.06 | 0 | 0.025 |
| Example 7 | 10 | Nitrogen | 0.16 | 0 | 2 | Hydrogen | 0.66 | 0 | 0.024 |
| Example 8 | 10 | Nitrogen | 0.16 | 0 | 2 | Hydrogen | 10 | 0 | 0.020 |
| Example 9 | 10 | Nitrogen | 0.16 | 1.5 | 2 | Hydrogen | 6.5 | 1.5 | 0.0001 |
| Example 10 | 10 | Nitrogen | 0.16 | 5 | 2 | Hydrogen | 6.5 | 5 | 0.0001 |
| Example 11 | 10 | Nitrogen | 0.16 | 10 | 2 | Hydrogen | 6.5 | 10 | 0.0001 |
| Example 12 | 10 | Hydrogen | 0.16 | 5 | 2 | Nitrogen | 6.5 | 1.5 | 0.0001 |
| Example 13 | 10 | Nitrogen | 0.16 | 5 | 2 | Nitrogen | 6.5 | 1.5 | 0.0001 |
| Example 14 | 10 | Hydrogen | 0.16 | 5 | 2 | Hydrogen | 6.5 | 1.5 | 0.0001 |

**Table 2**

| | Material of the circular member 32 | Material of the cylindrical member 35 | Amount of silicon adhering to the reaction vessel 11 (mm/H) |
|---|---|---|---|
| Example 15 | Ceramics containing silicon nitride | Ceramics containing silicon nitride | 0.0001 |
| Example 16 | Ceramics containing silicon carbide | Ceramics containing silicon carbide | 0.0001 |
| Example 17 | Quartz glass | Quartz glass | 0.0001 |
| Example 18 | Ceramics containing aluminum oxide | Ceramics containing aluminum oxide | 0.0001 |
| Example 19 | Ceramics containing zirconium oxide | Ceramics containing zirconium oxide | 0.0001 |

## Claims

1. A silicon manufacturing apparatus comprising a tubular reaction vessel and a means for heating a reaction region including at least a bottom end portion of the reaction vessel to at least a melting point of silicon, wherein the chlorosilanes and hydrogen are supplied to the reaction vessel from a gas supply pipe installed on the upper side of the reaction vessel, silicon is deposited to the inside wall of the reaction vessel that has been heated, and the deposited silicon is withdrawn from an opening at the bottom end portion of the reaction vessel, further comprising:
a first gas supply port that is formed by a circular slit and that supplies a sealing gas and/or an etching gas to the bottom end portion, on the peripheral side around the bottom end portion of the reaction vessel, and
a second gas supply port that supplies a sealing gas and/or an etching gas to a wall face of the member forming the first gas supply port at the outside periphery of the first gas supply port, at the position separate from the first gas supply port.

2. A silicon manufacturing apparatus as defined in claim 1, wherein the first gas supply port is formed by a gap between the peripheral face of the reaction vessel and the inner circumferential face of a circular member formed adjacently to the peripheral side of the reaction vessel, and the second gas supply port supplies a sealing gas and/or an etching gas to a wall face of the circular member at the outside periphery of the first gas supply port.

3. A silicon manufacturing apparatus as defined in claim 1, wherein the second gas supply port supplies a sealing gas and/or an etching gas to the bottom face or the inner circumferential face of the circular member at the outside periphery of the first gas supply port.

## Patentansprüche

1. Vorrichtung zur Herstellung von Silikon, umfassend ein röhrenförmiges Reaktionsgefäß und ein Mittel zum Erhitzen eines Reaktionsbereichs, beinhaltend mindestens einen unteren Endabschnitt des Reaktionsgefäßes, auf mindestens einen Schmelzpunkt von Silikon, wobei Chlorsilane und Wasserstoff dem Reaktionsgefäß von einer Gasversorgungsleitung, die auf der oberen Seite des Reaktionsgefäßes angebracht ist, zugeführt werden, Silikon sich an der Innenwand des Reaktionsgefäßes, das erhitzt wurde, abscheidet, und das abgeschiedene Silikon von einer Öffnung am unteren Endabschnitt des Reaktionsgefäßes entnommen wird, weiter umfassend:
eine erste Gasversorgungsöffnung auf der Peripherieseite um den unteren Endabschnitt des Reaktionsgefäßes, die durch eine kreisförmige Öffnung gebildet ist und die dem unteren Endabschnitt ein Sperr- und/oder ein Ätzgas zuführt, und
eine zweite Gasversorgungsöffnung, die ein Sperr- und/oder ein Ätzgas zu einer Wandfläche des Elements, das an der äußeren Peripherieseite der ersten Gasversorgungsöffnung die erste Gasversorgungsöffnung bildet, an der Position getrennt von der ersten Gasversorgungsöffnung zuführt.

2. Vorrichtung zur Herstellung von Silikon nach Anspruch 1, wobei die erste Gasversorgungsöffnung durch einen Spalt zwischen der Peripherieseite des Reaktionsgefäßes und der Innenumfangsseite eines kreisförmigen Elements, das angrenzend an die Peripherieseite des Reaktionsgefäßes ausgebildet ist, und die zweite Gasversorgungsöffnung einer Wandseite des kreisförmigen Elements an der äußeren Peripherieseite der ersten Gasversorgungsöffnung ein Sperr- und/oder ein Ätzgas zuführt.

3. Vorrichtung zur Herstellung von Silikon nach Anspruch 1, wobei die zweite Gasversorgungsöffnung der Unterseite oder der Innenumfangsseite des kreisförmigen Elements an der äußeren Peripherie der ersten Gasversorgungsöffnung ein Sperr- und/oder ein Ätzgas zuführt.

## Revendications

1. Appareil de fabrication de silicium comprenant une cuve de réaction tubulaire et un moyen permettant de chauffer une région de réaction incluant au moins une partie d'extrémité de fond de la cuve de réaction à au moins un point de fusion de silicium, dans lequel les chlorosilanes et l'hydrogène sont fournis à la cuve de réaction depuis un tuyau d'alimentation en gaz installé sur le côté supérieur de la cuve de réaction, du silicium est déposé sur la paroi intérieure de la cuve de réaction qui a été chauffée, et le silicium déposé est retiré par une ouverture au niveau de la partie d'extrémité de fond de la cuve de réaction, comprenant en outre :
un premier orifice d'alimentation en gaz qui est formé par une fente circulaire et qui fournit un gaz d'étanchéité et/ou un gaz de gravure à la partie d'extrémité de fond, sur le côté périphérique autour de la partie d'extrémité de fond de la cuve de réaction, et
un second orifice d'alimentation en gaz qui fournit un gaz d'étanchéité et/ou un gaz de gravure à une face de paroi de l'organe formant le premier orifice d'alimentation en gaz à la périphérie extérieure du premier orifice d'alimentation en gaz, au niveau de la position séparée du premier orifice d'alimentation en gaz.

2. Appareil de fabrication de silicium selon la revendication 1, dans lequel le premier orifice d'alimentation en gaz est formé par un écartement entre la face périphérique de la cuve de réaction et la face circonférentielle interne d'un organe circulaire formé de façon adjacente au côté périphérique de la cuve de réaction, et le second orifice d'alimentation en gaz fournit un gaz d'étanchéité et/ou un gaz de gravure à une face de paroi de l'organe circulaire à la périphérie extérieure du premier orifice d'alimentation en gaz.

3. Appareil de fabrication de silicium selon la revendication 1, dans lequel le second orifice d'alimentation en gaz fournit un gaz d'étanchéité et/ou un gaz de gravure à la face de fond ou la face circonférentielle interne de l'organe circulaire à la périphérie extérieure du premier orifice d'alimentation en gaz.
